(19) Europäisches Patentamt European Patent Office Office européen des brevets

(11) **EP 2 084 503 B1**

(12) **FASCICULE DE BREVET EUROPEEN**

(45) Date de publication et mention de la délivrance du brevet:
**12.05.2010 Bulletin 2010/19**

(21) Numéro de dépôt: **07870318.8**

(22) Date de dépôt: **21.11.2007**

(51) Int Cl.:
***G01J 9/00*** *(2006.01)*

(86) Numéro de dépôt international:
**PCT/FR2007/001914**

(87) Numéro de publication internationale:
**WO 2008/074939 (26.06.2008 Gazette 2008/26)**

(54) **DISPOSITIF DE DETECTION D'INTERFERENCES MONOLITHIQUE INTEGRE**

INTEGRIERTE MONOLITHISCHE INTERFERENZERKENNUNGSVORRICHTUNG

INTEGRATED MONOLITHIC INTERFERENCE DETECTION DEVICE

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **21.11.2006 FR 0610179**

(43) Date de publication de la demande:
**05.08.2009 Bulletin 2009/32**

(73) Titulaire: **Centre National de la Recherche Scientifique- CNRS**
**75794 Paris Cedex 16 (FR)**

(72) Inventeurs:
• **ARGUEL, Philippe**
  **31400 Toulouse (FR)**
• **LOZES, Françoise**
  **31320 Castanet Tolosan (FR)**
• **SARRABAYROUSE, Gérard**
  **32330 Mouchan (FR)**
• **BOUCHARD, Olivier**
  **32220 Lombez (FR)**

(74) Mandataire: **Novagraaf Technologies**
**122 rue Edouard Vaillant**
**92593 Levallois-Perret Cedex (FR)**

(56) Documents cités:
• **ARGUEL P ET AL: "A monolithic phase measurement photodetector" PROCEEDINGS OF IEEE SENSORS 2003. 2ND. IEEE INTERNATIONAL CONFERENCE ON SENSORS. TORONTO, CANADA, OCT. 22 - 24, 2003, IEEE INTERNATIONAL CONFERENCE ON SENSORS, NEW YORK, NY : IEEE, US, vol. VOL. 2 OF 2. CONF. 2, 22 octobre 2003 (2003-10-22), pages 783-786Vol2, XP010691014 ISBN: 0-7803-8133-5**
• **JOURLIN Y ET AL: "MONOLITHIC DIFFRACTIVE INTERFERENCE DETECTOR ON SILICON" PROCEEDINGS OF THE SPIE, SPIE, BELLINGHAM, VA, US, vol. 5251, no. 1, 19 février 2004 (2004-02-19), pages 172-177, XP008053551 ISSN: 0277-786X**
• **CSUTAK S M ET AL: "CMOS-COMPTABILE PLANAR SILICON WAVEGUIDE-GRATING-COUPLER PHOTODECTORS FABRICATED ON SILICON-ON-INSULATOR (SOI) SUBSTRATES" IEEE JOURNAL OF QUANTUM ELECTRONICS, IEEE SERVICE CENTER, PISCATAWAY, NJ, US, vol. 38, no. 5, mai 2002 (2002-05), pages 477-480, XP001116532 ISSN: 0018-9197**

**EP 2 084 503 B1**

## Description

L'invention se rapporte à un dispositif pour détecter une différence de phase entre deux faisceaux lumineux, ledit dispositif comprenant :

- un réseau de diffraction apte à générer un champ d'interférence entre lesdits deux faisceaux lumineux ;
- une photodiode agencée pour recevoir ledit champ d'interférence ;

ledit réseau de diffraction étant intégré à ladite photodiode.

L'invention se rapporte également à un procédé de fabrication d'un tel dispositif.

Un tel dispositif est connu de la publication « A Monolithic Optical Phase-Shift Detector on Silicon », Arguel et al., IEEE Sensors Journal, Decembre 2005.

Dans cette publication, le réseau de diffraction est un réseau de phase intégré à la photodiode. Dans le domaine de la micro-électronique, l'intégration d'un réseau de diffraction peut prendre soit la forme d'une gravure, soit la forme d'un dépôt. Dans la publication susmentionnée, le réseau de phase est gravé dans la photodiode.

Ce réseau de phase comprend une pluralité de créneaux gravés dans la photodiode, et il a été démontré dans la publication susmentionnée, que, dans les conditions d'incidence de Littrow, des interférences entre les deux faisceaux incidents sur le réseau, étaient détectables de façon optimale par la photodiode sous la forme d'un photocourant. L'intensité du photocourant généré dans le dispositif de la publication a la forme suivante :

$$I(\Delta\varphi) = A - B.\cos(\Delta\varphi),$$

$\Delta\varphi$ étant la différence de phase entre les deux faisceaux incidents sur le réseau de phase, A et B dépendant des caractéristiques des faisceaux incidents et des paramètres géométriques du réseau de phase, notamment la hauteur des créneaux formant le réseau de phase. Selon la formule ci-dessus, le contraste de l'intensité du photocourant généré dans le dispositif est donc C=B/A.

Selon cette formule, les auteurs de la publication susmentionnée ont déterminé que le contraste maximum pouvant être obtenu avec un tel réseau de phase est de l'ordre de 15 % à 20 %.

Or, un tel contraste est insuffisant pour réaliser des mesures à la fois directes et précises de la différence de phase entre les deux faisceaux incidents.

Un tel dispositif est aussi connu de la publication « A monolithic phase measurement photodetector », Arguel et al, Proceedings of IEEE Sensors 2003, de la publication « Monolithic diffractive interference detector on silicon », Jourlin et al, Proceedings of the SPIE, ainsi que de la publication « CMOS - compatible planar silicon waveguide-grating-coupler photodetectors fabricated on SOI substrates », Csutak et al, IEEE Journal of Quantum Electronics.

L'invention vise notamment à pallier cet inconvénient.

Un des buts de l'invention est donc d'accroître le contraste d'un dispositif tel que décrit précédemment.

Ce but est atteint par un dispositif pour détecter une différence de phase entre deux faisceaux lumineux, ledit dispositif comprenant :

- un réseau de diffraction apte à générer un champ d'interférence entre lesdits deux faisceaux lumineux ;
- une photodiode agencée pour recevoir ledit champ d'interférence ;

ledit réseau de diffraction étant intégré à ladite photodiode, dans lequel ledit réseau de diffraction est un réseau d'amplitude.

Un réseau d'amplitude comprend une succession de zones opaques et transparentes aux faisceaux incidents. De la sorte, les coefficients de diffraction en transmission dans la photodiode varient fortement en fonction de la différence de phase entre les deux faisceaux. Ainsi, le contraste de l'intensité détectée par la photodiode augmente fortement par rapport au dispositif intégrant un réseau de phase tel que connu de l'art antérieur.

Au contraire, les réseaux de phase de l'art antérieur ne permettait pas cette augmentation du contraste.

La Demanderesse a notamment démontré que le contraste obtenu pouvait atteindre des valeurs supérieures à 70 %.

Afin de faciliter la fabrication du dispositif susmentionné et d'en diminuer le coût de fabrication, ledit réseau d'amplitude peut être un réseau métallique déposé sur ladite photodiode. La technique d'intégration par dépôt métallique est en effet bien maîtrisée par l'homme du métier dans le domaine de la micro-électronique.

Toujours dans ce mode de réalisation, le dispositif susmentionné comprend des contacts métalliques inférieurs et supérieurs, un générateur de tension étant susceptible d'être connecté entre les contacts métalliques inférieurs et supérieurs de sorte à générer une différence de potentiel au sein de ladite photodiode, le réseau d'amplitude étant en contact électrique avec les contacts supérieurs. De la sorte, puisque le réseau d'amplitude est métallique et qu'il est en contact avec les contacts électriques supérieurs, la longueur de diffusion des porteurs est réduite, ce qui permet d'améliorer la mesure du photocourant généré dans le dispositif.

En outre, afin de faciliter la fabrication du dispositif susmentionné et d'en diminuer le coût de fabrication, ladite photodiode peut être une photodiode p-n.

Afin de permettre la détection de faisceaux pour des longueurs d'onde dans le visible et le proche infrarouge, ladite photodiode peut être une photodiode au silicium.

Afin de permettre la détection de faisceaux pour des longueurs d'onde dans l'infrarouge, ladite photodiode peut être une photodiode III-V.

Dans les deux cas précédents, le dispositif susmentionné possède l'avantage d'être adapté aux mesures de différences de phase en fonction de la longueur d'onde des faisceaux incidents sur le réseau d'amplitude.

Afin d'obtenir une bonne photodétection par la photodiode, et de permettre l'adaptation à la longueur d'onde incidente, dans le dispositif susmentionné, ladite photodiode ayant une région active, et lesdits deux faisceaux ayant une même longueur d'onde, ladite région active peut être positionnée dans ladite photodiode de sorte qu'une conversion photoélectrique des photons à ladite longueur d'onde ait lieu dans ladite région active.

En effet, dans une telle photodiode, la détection sera alors fortement améliorée si la conversion photoélectrique a lieu dans la zone active. La photodiode peut donc être choisie en fonction de la longueur d'onde à détecter pour satisfaire cette condition.

L'invention se rapporte également à un procédé de fabrication d'un dispositif pour détecter une différence de phase entre deux faisceaux lumineux, ledit procédé comprenant des étapes consistant à :

- fournir une photodiode ;
- déposer ou graver un réseau d'amplitude sur ladite photodiode.

Ce procédé a l'avantage de pouvoir être réalisé par une technologie CMOS d'intégration et bénéficie donc de la maturité et de la large diffusion de cette technologie.

On décrit maintenant un mode de réalisation de l'invention en référence aux figures annexées dans lesquelles :

- FIG. 1 illustre un dispositif selon un mode de réalisation de l'invention ;
- FIG. 2 illustre de façon plus-détaillée- un dispositif selon un mode de réalisation de l'invention ;
- FIG. 3 illustre une vue du dessus d'un réseau d'amplitude selon l'invention ;
- FIG. 4 illustre l'évolution du contraste détecté en fonction,du rapport d'ouverture et du pas du réseau d'amplitude.

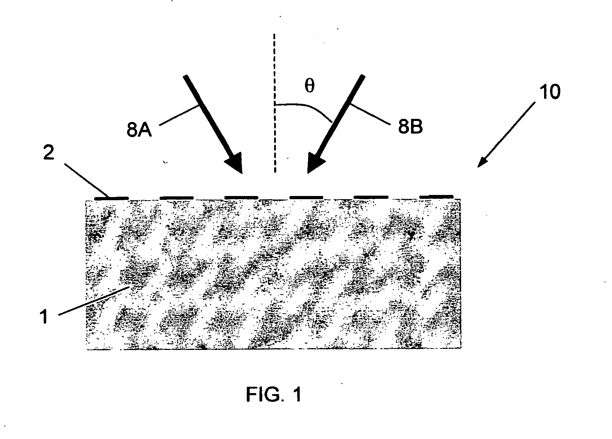

Illustré FIG. 1 de façon générale, un dispositif 10 selon l'invention comprend une photodiode 1 et un réseau d'amplitude 2. Le réseau d'amplitude 2 est intégré à la photodiode 1. Il peut être gravé dans ou déposé sur cette photodiode 1. L'intégration du réseau d'amplitude 2 à la photodiode 1 peut être réalisé par une technique d'intégration de type CMOS, de sorte que le dispositif 10 forme un dispositif monolithique. Le dispositif 10 est utilisé pour réaliser un micro-interféromètre intégré apte à détecter une différence de phase entre des faisceaux 8A et 8B. Les faisceaux 8A et 8B ont une longueur d'onde fixée.

La photodiode 1 est fabriquée par un procédé utilisant une technologie de type CMOS, comme ceci est décrit dans la publication « A Monolithic Optical Phase-Shift Detector on Silicon », Arguel et al., IEEE Sensors Journal, Decembre 2005.

Le réseau métallique est fabriqué par une technique de lithographie, par exemple par écriture électronique de motifs dans une couche de résine PMMA. La couche de métal déposée pour la réalisation du réseau métallique présente une épaisseur la rendant opaque à la longueur d'onde des faisceaux pour lesquels on désire déterminer la différence de phase.

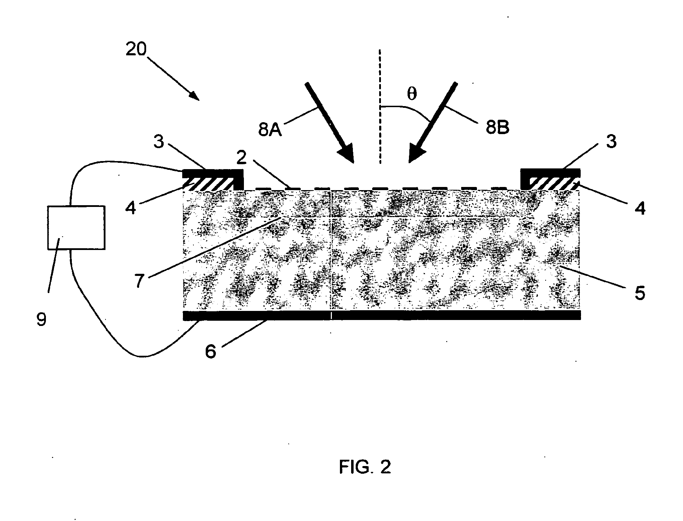

On décrit maintenant plus en détail un dispositif selon l'invention en référence à la FIG. 2

Illustré FIG.2, un dispositif 20 selon l'invention comprend une photodiode de silicium 5 comprenant une couche inférieure métallique 6, une jonction p-n 7, des zones métalliques supérieures 3, des couches de dioxyde de silicium $SiO_2$ 4. Un générateur de tension 9 peut être connecté entre les contacts métalliques supérieurs 3 et la couche inférieure métallique 6 de sorte à polariser la photodiode 5. De façon connue en soi pour une photodiode, un signal lumineux émis vers la photodiode 5 génère un photocourant entre les contacts métalliques 3 et 6, ce photocourant étant transmis dans la direction de polarisation de la photodiode telle qu'imposée par la différence de potentiel issue du générateur de tension 9. La mesure de ce photocourant permet d'obtenir des informations sur le signal lumineux. Le dispositif 20 comprend également un réseau d'amplitude 2. Comme précédemment, la photodiode 5 peut être fabriquée par le procédé décrit dans la publication « A Monolithic Optical Phase-Shift Detector on Silicon », Arguel et al., IEEE Sensors Journal, Decembre 2005.

Le dispositif 20 est utilisé pour réaliser un micro-interféromètre intégré apte à détecter une différence de phase entre des faisceaux 8A et 8B. Les faisceaux 8A et 8B ont une longueur d'onde en lumière rouge d'environ 650 nanomètres sous une incidence voisine de θ=30°. Les conditions opératoires respectent l'ordre 1 de Littrow, de sorte que la valeur du pas du réseau est de l'ordre de 0,6 micromètre. La photodiode 5 est une photodiode au silicium comprenant une jonction p-n 7 définissant une zone active. La position de la zone active est choisie de sorte que la conversion photo-électrique ait lieu dans la zone active.

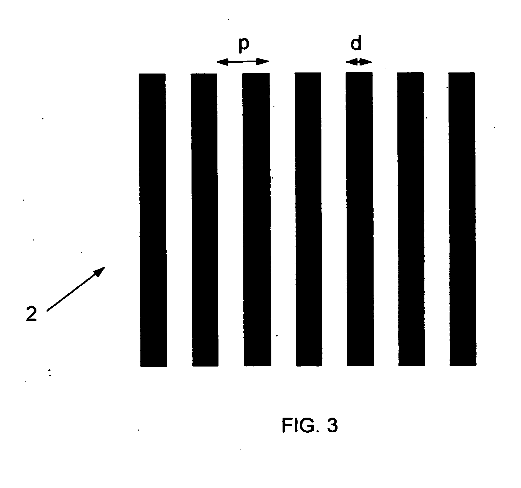

Le réseau métallique 2 présente une couche d'aluminium d'environ 50 nm d'épaisseur obtenue par pulvérisation cathodique. Le réseau métallique 2 a un rapport d'ouverture d'environ 0,65 et couvre environ 95% de la surface active de la photodiode. Il est fabriqué par une technique connue du type lift-off. La FIG. 3 illustre une vue du dessus d'un réseau d'amplitude métallique 2 selon l'invention. Le réseau 2 est un réseau métallique unidimensionnel de pas p, de largeur de métal d, et de rapport d'ouverture d/p.

Il est possible de tester la détection de la différence de phase du dispositif susmentionné grâce à un montage de test tel que décrit dans la publication susmentionnée « A Monolithic Optical Phase-Shift Detector on Silicon », Arguel et al., IEEE Sensors Journal, Décembre 2005. Un tel montage de test permet de simuler le fonctionnement d'un capteur optique de déplacement.

Le signal électrique recueilli lors des tests réalisés par la demanderesse indique que le contraste brut est égal à 66,2 %. Ce contraste peut être évalué à environ 75% pour un réseau d'amplitude recouvrant totalement la photodiode 5.

Par une optimisation des caractéristiques du réseau d'amplitude, il est même possible d'obtenir des contrastes supérieurs à 90%.

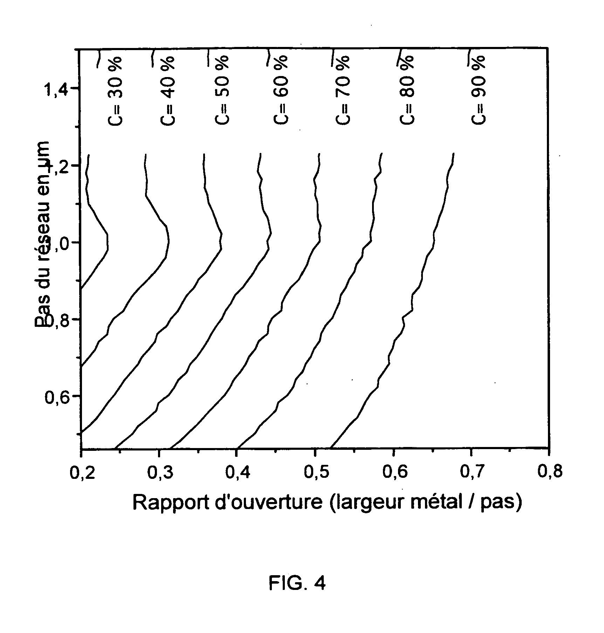

Le contraste obtenu par le dispositif de l'invention est illustré FIG. 4 en fonction du pas du réseau en micromètre et du rapport d'ouverture. Le contraste en pourcentage est indiqué sur la FIG. 4.

Par ailleurs, lorsque le réseau d'amplitude 2 est un réseau métallique, il peut être relié aux zones métalliques supérieures 3. Dans ce mode de réalisation, le réseau d'amplitude métallique 2 a donc également une fonction de contact électrique qui permet d'améliorer la mesure du photocourant traversant la photodiode.

Selon un autre mode de réalisation de l'invention, le réseau d'amplitude 2 est un réseau bidimensionnel métallique présentant une structure périodique de trous. De la sorte, il est possible d'accéder, non seulement à la différence de phase entre deux faisceaux incidents, mais également à leurs polarisations.

## Revendications

**1.** Dispositif (10, 20) pour détecter une différence de phase entre deux faisceaux lumineux, ledit dispositif comprenant :

    - un réseau de diffraction (2) apte à générer un champ d'interférence entre lesdits deux faisceaux lumineux ;
    - une photodiode (1, 5) agencée pour recevoir ledit champ d'interférence ;

ledit réseau de diffraction étant intégré à ladite photodiode, **caractérisé en ce que** ledit réseau de diffraction est un réseau d'amplitude (2).

**2.** Dispositif selon la revendication 1 dans lequel ledit réseau d'amplitude est un réseau métallique déposé sur ladite photodiode.

**3.** Dispositif selon la revendication 2, comprenant des contacts métalliques inférieurs (6) et supérieurs (3), un générateur de tension (9) étant susceptible d'être connecté entre les contacts métalliques inférieurs (6) et supérieurs (3) de sorte à générer une différence de potentiel au sein de ladite photodiode, le réseau d'amplitude (2) étant en contact électrique avec les contacts supérieurs (3).

**4.** Dispositif selon l'une des revendications précédentes dans lequel ladite photodiode est une photodiode p-n.

**5.** Dispositif selon l'une des revendications précédentes, dans lequel ladite photodiode est une photodiode III-V.

**6.** Dispositif selon l'une des revendications 1 à 4, dans lequel ladite photodiode est une photodiode au silicium.

**7.** Dispositif selon l'une des revendications précédentes dans lequel ladite photodiode a une région active, et lesdits deux faisceaux ont une même longueur d'onde, ladite région active étant positionnée dans ladite photodiode de sorte qu'une conversion photoélectrique des photons à ladite longueur d'onde ait lieu dans ladite région active.

**8.** Dispositif selon l'une des revendications précédentes dans lequel ledit réseau d'amplitude a un pas, ledit pas respectant les conditions de Littrow d'ordre 1.

**9.** Dispositif selon l'une des revendications précédentes dans lequel ledit réseau d'amplitude est un réseau monodimensionnel.

**10.** Dispositif selon l'une des revendications 1 à 8 dans lequel ledit réseau est un réseau bidimensionnel.

**11.** Procédé de fabrication d'un dispositif pour détecter une différence de phase entre deux faisceaux lumineux, ledit procédé comprenant des étapes consistant à :

    - fournir une photodiode ;
    - déposer ou graver un réseau d'amplitude sur ladite photodiode.

## Claims

**1.** Device (10, 20) for detecting a phase difference between two light beams, the said device comprising:

    - a diffraction grating (2) able to generate an interference field between the said two light beams;
    - a photodiode (1, 5) arranged to receive the said interference field;

the said diffraction grating being integrated into the said photodiode, **characterized in that** the said diffraction grating is an amplitude grating (2).

2. Device according to Claim 1 in which the said amplitude grating is a metallic grating deposited on the said photodiode.

3. Device according to Claim 2, comprising lower (6) and upper (3) metallic contacts, a voltage generator (9) being able to be connected between the lower (6) and upper (3) metallic contacts so as to generate a potential difference within the said photodiode, the amplitude grating (2) being in electrical contact with the upper contacts (3).

4. Device according to one of the preceding claims in which the said photodiode is a p-n photodiode.

5. Device according to one of the preceding claims, in which the said photodiode is a III-V photodiode.

6. Device according to one of Claims 1 to 4, in which the said photodiode is a silicon-based photodiode.

7. Device according to one of the preceding claims in which the said photodiode has an active region, and the said two beams have one and the same wavelength, the said active region being positioned in the said photodiode so that a photoelectric conversion of the photons at the said wavelength takes place in the said active region.

8. Device according to one of the preceding claims in which the said amplitude grating has a spacing, the said spacing complying with the Littrow conditions of order 1.

9. Device according to one of the preceding claims in which the said amplitude grating is a one-dimensional grating.

10. Device according to one of Claims 1 to 8 in which the said grating is a two-dimensional grating.

11. Method of manufacturing a device for detecting a phase difference between two light beams, the said method comprising steps consisting in:

    - providing a photodiode;
    - depositing or etching an amplitude grating on the said photodiode.

**Patentansprüche**

1. Vorrichtung (10, 20) zum Erfassen einer Phasendifferenz zwischen zwei Strahlenbündel, wobei die Vorrichtung umfasst:

    - ein Diffraktionsgitter (2), das so ausgebildet ist, dass dieses ein Interferenzfeld zwischen den zwei Strahlenbündeln erzeugt;
    - eine Photodiode (1, 5), die zur Aufnahme des Interferenzfeldes angeordnet ist;

wobei das Diffraktionsgitter in die Photodiode integriert ist, **dadurch gekennzeichnet, dass** das Diffraktionsgitter ein Amplitudengitter (2) ist.

2. Vorrichtung nach Anspruch 1, in welcher das Amplitudengitter ein auf der Photodiode angeordnetes Metallgitter ist.

3. Vorrichtung nach Anspruch 2, mit unteren (6) und oberen (3) Metallkontakten, wobei ein Spannungserzeuger (9) zwischen den unteren (6) und oberen (3) Metallkontakten angeschlossen werden kann, derart, dass dieser eine Potentialdifferenz innerhalb der Photodiode erzeugt, wobei das Amplitudengitter (2) in elektrischem Kontakt mit den oberen Kontakten (3) steht.

4. Vorrichtung nach einem der vorhergehenden Ansprüche, in welcher die Photodiode eine p-n Photodiode ist.

5. Vorrichtung nach einem der vorhergehenden Ansprüche, in welcher die Photodiode eine III-V Photodiode ist.

6. Vorrichtung nach einem der Ansprüche 1 bis 4, in welcher die Photodiode eine Photodiode aus Silizium ist.

7. Vorrichtung nach einem der vorhergehenden Ansprüche, in welcher die Photodiode eine aktive Region hat und die zwei Bündel die gleiche Wellenlänge haben, wobei die aktive Region in der Photodiode derart positioniert ist, dass eine photoelektrische Konversion von Photonen nach ihrer Wellenlänge in der aktiven Region erfolgt.

8. Vorrichtung nach einem der vorhergehenden Ansprüche, in welcher das Amplitudengitter eine Schrittweite hat, wobei die Schrittweite die Littrow-Bedingungen erster Ordnung erfüllt.

9. Vorrichtung nach einem der vorhergehenden Ansprüche, in welcher das Amplitudengitter ein monodimensionales Gitter ist.

10. Vorrichtung nach einem der Ansprüche 1 bis 8, in welcher das Gitter ein bidimensionales Gitter ist.

11. Verfahren zur Herstellung einer Vorrichtung, um eine Phasendifferenz zwischen zwei Strahlenbündeln zu erfassen, wobei das Verfahren die Schritte umfasst, bestehend aus:

- Bereitstellen einer Photodiode;
- Anordnen oder Ätzen eines Amplitudengitters auf der Photodiode.

FIG. 1

FIG. 2

FIG. 3

FIG. 4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **Arguel et al.** A Monolithic Optical Phase-Shift Detector on Silicon. *IEEE Sensors Journal,* Janvier 2005
- **Arguel et al.** A monolithic phase measurement photodetector. *Proceedings of IEEE Sensors,* 2003
- **Csutak et al.** CMOS - compatible planar silicon waveguide-grating-coupler photodetectors fabricated on SOI substrates. *IEEE Journal of Quantum Electronics*
- **Arguel et al.** A Monolithic Optical Phase-Shift Detector on Silicon. *IEEE Sensors Journal,* Décembre 2005